(19) Europäisches Patentamt
European Patent Office
Office européen des brevets

(11) **EP 1 306 903 A1**

(12) **EUROPEAN PATENT APPLICATION**
published in accordance with Art. 158(3) EPC

(43) Date of publication:
**02.05.2003 Bulletin 2003/18**

(51) Int Cl.⁷: **H01L 27/06**, H01L 21/8232,
H01L 21/337, H01L 21/338,
H01L 29/808, H01L 29/812,
H02M 7/537

(21) Application number: **00948304.1**

(22) Date of filing: **28.07.2000**

(86) International application number:
**PCT/JP00/05091**

(87) International publication number:
**WO 02/011210 (07.02.2002 Gazette 2002/06)**

(84) Designated Contracting States:
**AT BE CH CY DE DK ES FI FR GB GR IE IT LI LU
MC NL PT SE**

(71) Applicant: **Sumitomo Electric Industries, Ltd.**
**Osaka-shi, Osaka 541-0041 (JP)**

(72) Inventors:
• **HARADA, Shin**
  **Osaka-shi, Osaka 554-0024 (JP)**
• **HIROTSU, Kenichi**
  **Osaka-shi, Osaka 554-0024 (JP)**
• **MATSUNAMI, Hiroyuki**
  **Yawata-shi, Kyoto 614-8351 (JP)**
• **KIMOTO, Tsunenobu**
  **Kyoto-shi, Kyoto 612-8031 (JP)**

(74) Representative: **Grünecker, Kinkeldey,**
  **Stockmair & Schwanhäusser Anwaltssozietät**
  **Maximilianstrasse 58**
  **80538 München (DE)**

(54) **INVERTER**

(57) An inverter employing an FET structure converting device is featured in that the above-described converting devices S1 through S6 are formed of SiC (Silicon Carbide)-JFET, wherein it is possible to achieve an inverter whose switching frequency is high and loss is small.

FIG. 3

**Description**

Technical field

The present invention relates to an inverter (DC-AC converting device) having a converting device of FET structure employed therein.

Background arts

Si-MOSFET and Si-IGBT (Insulated Gate Bipolar Transistor) have been employed as semiconductor elements used for an inverter for low voltage (of 600V or less).

In the case of Si-MOSFET, the amount of loss is inversely proportionate to the carrier density in an Si semiconductor. In order to decrease the loss, the carrier density may be increased. However, as the carrier density increases, the withstand voltage of a device which is determined by a breakdown voltage decreases. For example, in the case of Si, the carrier density to make the withstand voltage into 200V becomes as low a value as $10^{15}$/cm$^3$. Therefore, the carrier density could not be increased, which is a reason for the loss of Si-MOSFET having been large.

Also, since, in the MOSFET, an electric current flows in the phase boundary between gate insulation layers SiO$_2$ and Si, the MOSFET tends to be affected by defects, and the carrier mobility decreases. Accordingly, the loss will increase.

In the case of Si-IGBT, since a considerable amount of time is required to diminish minority carriers in a bipolar device, and the switching frequency cannot be increased, the loss is made large.

There are many cases where a normally-off type device is employed in converting devices that are used for an inverter, in order to provide protection for such as the case as a short circuit fault of a control circuit, etc. The MOSFET meets the conditions. JFET is generally known for a normally-off type.

It is an object of the present invention to provide an inverter whose switching frequency is high and loss is small.

DISCLOSURE OF THE INVENTION

An inverter according to the present invention is an inverter having a converting device of an FET structure, wherein the converting device is formed of a SiC (Silicon Carbide)-JFET (Junction FET).

The SiC-JFET is employed for the following reasons:

(1) Although Si-JFET has conventionally been produced, the carrier density was low, and the loss thereof was large. If SiC is used instead of Si, it is possible to increase the carrier density and reduce the loss thereof.

(2) In the Si-JFET, the carrier density was low, and the switching frequency was also low. It could be confirmed through calculations that, since the SiC-JFET has high carrier density, the switching frequency can be obtained from several hundreds of MHz through several GHz. The switching frequency f of the JFET is expressed by

$$f = q\, NA\mu a^2 / \pi L^2 \varepsilon s$$

where q is electric charge, NA is carrier density, $\mu$ is carrier mobility, a is a channel depth, L is a channel length, and $\varepsilon s$ is permittivity. Herein NA = 1 x $10^{17}$/cm$^3$, $\mu$ = 300cm$^2$/Vsec, a = 300nm, L = 10$\mu$m, $\varepsilon s$ = 10 x $\varepsilon_0$ ($\varepsilon_0$ is permittivity in a vacuum), which are typical values for, for example, a 200V withstand voltage JFET, are substituted, wherein f = 1.4GHz can be obtained. Therefore, these are preferable to the inverter.

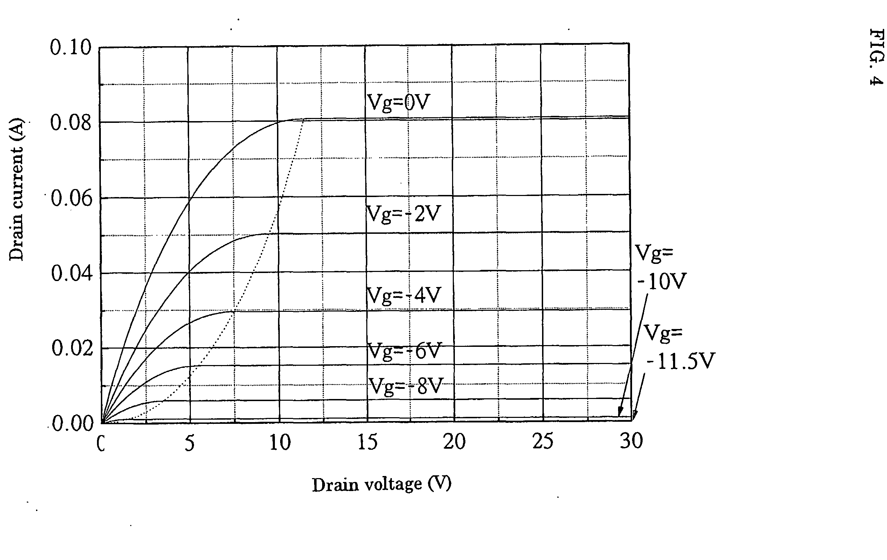

Figure 4 is a graph of a measurement of drain voltage-current characteristics where a SiC-JFET is produced, which has a channel area whose channel depth is 0.3 $\mu$m, channel length is 10$\mu$m, channel width is 700$\mu$m, and carrier density is 1.56 x $10^{17}$/cm$^3$. Vg represents gate voltage

(3) Since the converting device is composed of JFET, an electric current flows in bulk, the carrier mobility does not decrease, and the loss is small. Also, the drain ON-sate voltage is very small, one-fiftieth or so in comparison with Si-MOSFET. Therefore, the efficiency of SiC- JFET becomes 95% or more while the efficiency of Si-MOSFET is 85%.

To explain detail, in an inverter that converts, for example, 200V, the loss of Si-MOSFET is 7.5% for a constant loss (ON-voltage x current), and 7.5% for a switching loss, the total loss becomes 15% and the efficiency becomes 85%. On the other hand, in Sic-JET, since it is possible to lower the ON-voltage to one-fiftieth when a current yhat is equal to that of Si-MOSFET is caused to flow, the constant loss can be lowered. Accordingly, the efficiency becomes 95% or more.

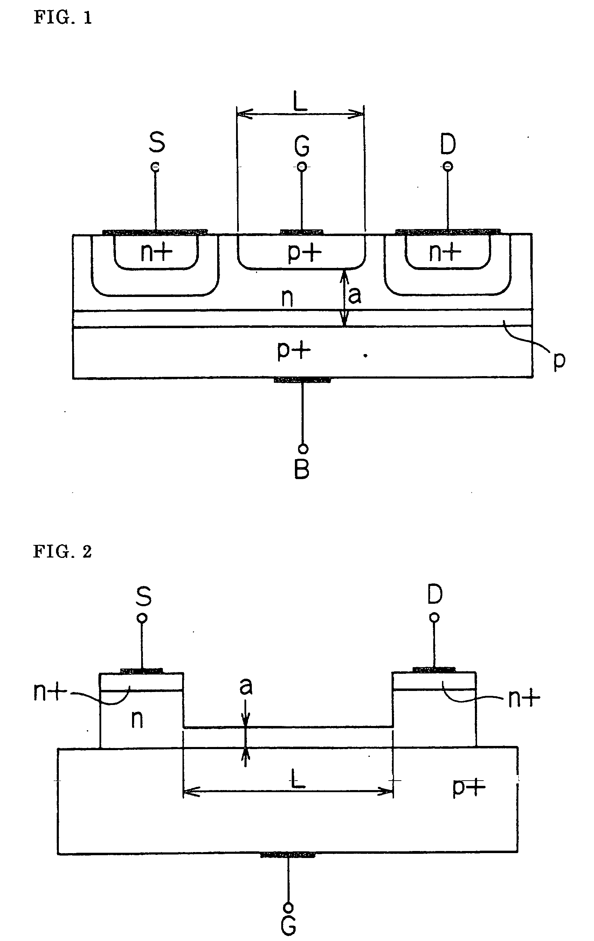

Any publicly known method may be employed to produce a JFET device using SiC. One of the methods is an -ion-implantation method, wherein as shown in Fig.1, an n-Sic layer is deposited on a p+SiC substrate by the epitaxial method. The substrate is provided with masking, and n+ areas that become a source electrode and a drain electrode are produced by the ion implantation method, and further a p+ area that becomes a gate electrode is produced by the same method. When producing the area p+, parts of a channel depth a and a channel length L are caused to remain. Annealing treatment is subsequently provided to activate the devices.

Another method for producing a SiC-JFET device is to produce a channel groove by a reactive ion etching method (RIE). As shown in Figure 2, an n-SiC layer is deposited on a p+SiC substrate by the epitaxial method, and an n+ layer is produced thereon. Using the RIE method, the substrate is provided with masking, wherein a part thereof is erased to cause channel areas (channel depth a and channel length L) to be formed.

The above-described SiC-JFET device is described about the normally-ON type, However, it can be handled as a normally-OFF type in a case in which the channel depth a meets the following expression.

$$a < \sqrt{\frac{2 \, \varepsilon s V_{bi}}{qN}}$$

(where q is electric charge, N is a carrier density in the channel, $\varepsilon s$ is permittivity, and $V_{bi}$ is a built-in potential).

BRIEF DESCRIPTION OF THE DRAWINGS

Figure 1 is a cross-sectional view showing a structure of a SiC-JFET that is produced by the ion implantation method;
Figure 2 is a cross-sectional view showing a structure of a SiC-JFET that is produced by the RIE method;
Figure 3 is a circuit diagram of an inverter to which the present invention applies; and
Figure 4 is a graph of a measurement of drain voltage-current characteristics of a SiC-JFET thus produced.

DESCRIPTION OF REFERENCE SYMBOLS

S1 through S6 are converting devices.

(Embodiments)

Hereinafter, a detailed description is given of an embodiment of the present invention with reference to the accompanying drawings.

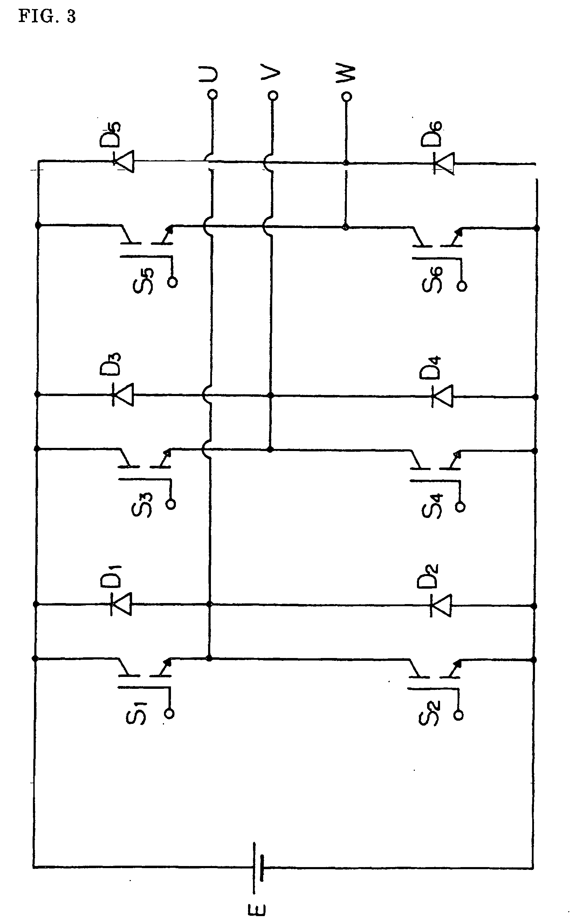

Figure 3 is a circuit diagram of a self-commutated inverter that converts DC input E to 3-phase AC outputs U, V, and W, wherein six switching devices S1 through S6 and six feedback diodes D1 through D6 are connected to each other in the form of a three-phase bridge.

The inverter itself has been publicly known. However, in the present invention, the switching devices S1 through S6 are composed of SiC-JFET converting devices. Also, the feedback diodes D1 through D6 are composed of SiC Schottky diodes.

Accordingly, it is possible to achieve an excellent inverter whose switching frequency is high and loss is small.

Also, the present invention is not limited to such a voltage-source self-commutated inverter as is shown in Fig.1. It may be applicable to current-source self-commutated inverters and other externally-commutated inverters.

Industrial applicability.

As has been described above, since a SiC-JFET is employed as a converting device in an inverter according to the invention, the inverter exhibits high switching frequency and small.

**Claims**

1. An inverter employing an FET structure converting device, wherein said converting device is formed of a SiC (Silicon Carbide)-JFET.

2. The inverter as set forth in Claim 1, wherein said SiC-JFET is a normally-OFF type.

3. The inverter as set forth in Claim 1, wherein said converting device further includes a SiC Schottky diode.

FIG. 1

FIG. 2

FIG. 3

FIG. 4

**INTERNATIONAL SEARCH REPORT**

International application No.

PCT/JP00/05091

A. CLASSIFICATION OF SUBJECT MATTER
Int.Cl$^7$   H01L27/06, H01L21/8232, H01L21/337, H01L21/338,
H01L29/808, H01L29/812, H02M 7/537

According to International Patent Classification (IPC) or to both national classification and IPC

B. FIELDS SEARCHED

Minimum documentation searched (classification system followed by classification symbols)
Int.Cl$^7$   H01L27/06, H01L21/8232, H01L21/337, H01L21/338,
H01L29/808, H01L29/812 , H02M 7/537

Documentation searched other than minimum documentation to the extent that such documents are included in the fields searched
Jitsuyo Shinan Koho         1922-1996      Toroku Jitsuyo Shinan Koho  1994-2000
Kokai Jitsuyo Shinan Koho   1971-2000      Jitsuyo Shinan Toroku Koho  1996-2000

Electronic data base consulted during the international search (name of data base and, where practicable, search terms used)
IEEE/IEE Electronic Library: (Silicon and Carbide or SiC) and JFET

C. DOCUMENTS CONSIDERED TO BE RELEVANT

| Category* | Citation of document, with indication, where appropriate, of the relevant passages | Relevant to claim No. |
|---|---|---|
| Y | JP 9-9627 A (Senken Electric Co., Ltd.), 10 January, 1997 (10.01.97), Claim 1; Column 5, line 27 to Column 6, line 10; Figs. 1 to 5; Column 7, line 47 to Column 8, line 2 (Family: none) | 1-3 |
| Y | Denki Gakkai Kenkyuu-kai Shiryou, EDD-99, 93-112 (JICST received on 05 November, 1999), pages 7 to 13, page 11, right column, line 10 to page 12, line 2 | 1-3 |
| A | IEEE Transactions on Nuclear Science, Vol. 39, No. 6 (December 1992) pages 1974 to 1980, page 1975, "II.SiC DEVICE DESCRIPTION" | 1-3 |
| A | JP 2000-77662 A (Hitachi, Ltd.), 14 March, 2000 (14.03.00), Claim 1; Column 3, line 48 to Column 4, line 11; Column 11, lines 14 to 21 (Family: none) | 1-3 |

☐ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 14 November, 2000 (14.11.00) | 28 November, 2000 (28.11.00) |

| Name and mailing address of the ISA/ | Authorized officer |
|---|---|
| Japanese Patent Office | |
| Facsimile No. | Telephone No. |

Form PCT/ISA/210 (second sheet) (July 1992)